# EUROPEAN PATENT SPECIFICATION

(11) **EP 2 560 213 B1**
(45) Date of publication and mention of the grant of the patent: **30.10.2019**
(21) Application number: 11763025.1
(22) Date of filing: 30.03.2011
(51) Int. Cl.: H01L 31/042, H01L 31/046, H01L 31/18, H01L 31/0216, H01L 31/0236

(54) **SOLAR PHOTOVOLTAIC DEVICE AND A PRODUCTION METHOD FOR THE SAME**
SOLAR-PHOTOVOLTAIK-VORRICHTUNG UND HERSTELLUNGSVERFAHREN DAFÜR
DISPOSITIF PHOTOVOLTAÏQUE SOLAIRE ET SON PROCÉDÉ DE PRODUCTION

(30) Priority: 30.03.2010 KR 20100028417
(43) Date of publication of application: 20.02.2013
(73) Proprietor: LG Innotek Co., Ltd., Seoul, 04637 (KR)
(72) Inventor: CHOI, Chul Hwan, Seoul 100-714 (KR)
(74) Representative: Novagraaf Technologies
(86) International application number: PCT/KR2011/002188
(87) International publication number: WO 2011/122853

(56) References cited:
- EP-A1- 1 956 659
- EP-A2- 2 101 358
- EP-A2- 2 166 578
- WO-A2-2009/120983
- CN-Y- 201 051 503
- DE-A1- 19 526 733
- JP-A- S58 121 688
- KR-A- 19980 017 427
- KR-A- 19980 068 248
- KR-A- 20090 017 760
- US-A1- 2006 130 891
- US-A1- 2010 051 099

## Description

### Technical Field

The embodiment relates to a solar cell and a method of fabricating the same.

### Background Art

Recently, as energy consumption is increased, a solar cell has been developed to convert solar energy into electrical energy as disclosed, for example, in documents EP1956659, CN201051503 and DE19526733.

In particular, a CIGS-based solar cell, which is a PN hetero junction apparatus having a substrate structure including a glass substrate, a metallic back electrode layer, a P type CIGS-based light absorbing layer, a high-resistance buffer layer, and an N type window layer, has been extensively used.

### Disclosure

### Technical Problem

The embodiment provides a solar cell having an improved external appearance and high efficiency and a method of fabricating the same.

### Technical Solution

A solar cell according to the embodiment includes a substrate, a back electrode layer on the substrate ; a light absorbing layer on the back electrode layer; a window layer, on the light absorbing layer, including a base layer and an anti-reflective pattern protruding from said base layer, the anti-reflective pattern including a first inclined surface, directed to a first direction, and a second inclined surface, directed to a second direction, the first inclined surface and the second inclined surface being inclined with respect to a top surface of the back electrode layer in mutually different directions; an anti-reflective layer provided on the window layer; ; wherein the anti-reflective layer has a first anti-reflective and a second anti-reflective layer, the first anti-reflective layer and the second anti-reflective layer being integrally formed with each other, wherein ends of the first inclined surface are connected with the second inclined surface and ends of the second inclined surface are connected with the first inclined surface; wherein the first anti-reflective layer is coated on the first inclined surface and having a first uniform thickness T1; wherein the second anti-reflective layer is coated on the second inclined surface and having a second uniform thickness T2 thinner than the first thickness T1; wherein the first thickness T1 is in a range of 100 nm to 500 nm; wherein the second thickness T2 is in a range of 50 nm to 450 nm; and wherein a difference between the first and second thicknesses T1 and T2 is in a range of 10 nm to 100 nm.

A method of fabricating a solar cell according to the embodiment includes the steps of forming a back electrode layer on a substrate; forming a light absorbing layer on the back electrode layer; forming a window layer, on the light absorbing layer, including a base layer and an anti-reflective pattern protruding from said base layer, the anti-reflective pattern including a first inclined surface, directed to a first direction, and a second inclined surface, directed to a second direction, the first inclined surface and the second inclined surface being inclined with respect to a top surface of the back electrode layer in mutually different directions; forming an anti-reflective layer on the window layer; wherein the anti-reflective layer has a first anti-reflective layer and a second anti-reflective layer, the first anti-reflective layer and the second anti-reflective layer being integrally formed with each other; wherein ends of the first inclined surface are connected with the second inclined surface and ends of the second inclined surface are connected with the first inclined surface; wherein the first anti-reflective layer is coated on the first inclined surface and having a first uniform thickness T1; and wherein the second anti-reflective layer is coated on the second inclined surface and having a second uniform thickness T2 thinner than the first thickness; wherein the first thickness T1 is in a range of 100 nm to 500 nm; wherein the second thickness T1 is in a range of 50 nm to 450 nm; and wherein a difference between the first and second thicknesses T1 and T2 is in a range of 10 nm to 100 nm.

### Advantageous Effects

The solar cell according to the embodiment includes the first and second anti-reflective layers, which are disposed on the protrusion pattern and having thicknesses different from each other. In particular, the first anti-reflective layer is disposed at one side of the protrusion pattern and the second reflective layer is disposed at the other side of the protrusion pattern.

Thus, the color of the window layer may be changed according to the viewing direction. This is because the wavelength causing the constructive interference in the first anti-reflective layer is different from the wavelength causing the constructive interference in the second anti-reflective layer.

Therefore, the solar cell according to the embodiment may have the improved external appearance.

In addition, the incident rate of the window layer may be increased due to the protrusion pattern, the first anti-reflective layer and the second anti-reflective layer. Thus, the efficiency of the solar cell according to the embodiment can be improved.

### Description of Drawings

FIG. 1 is a sectional view showing a solar cell according to the embodiment;
FIGS. 2 to 4 are perspective views showing various examples of anti-reflective patterns; and
FIGS. 5 to 7 are views showing the process for fabricating a solar cell according to the embodiment.

### Best Mode

### Mode for Invention

In the description of the embodiments, it will be understood that when a substrate, a film, an electrode, a groove, or a layer is referred to as being "on" or "under" another substrate, another film, another electrode, another groove, or another layer, it can be "directly" or "indirectly" on the other substrate, the other film, the other electrode, the other groove, or the other layer, or one or more intervening layers may also be present. Such a position of the layer has been described with reference to the drawings. The size of the elements shown in the drawings may be exaggerated for the purpose of explanation and may not utterly reflect the actual size.

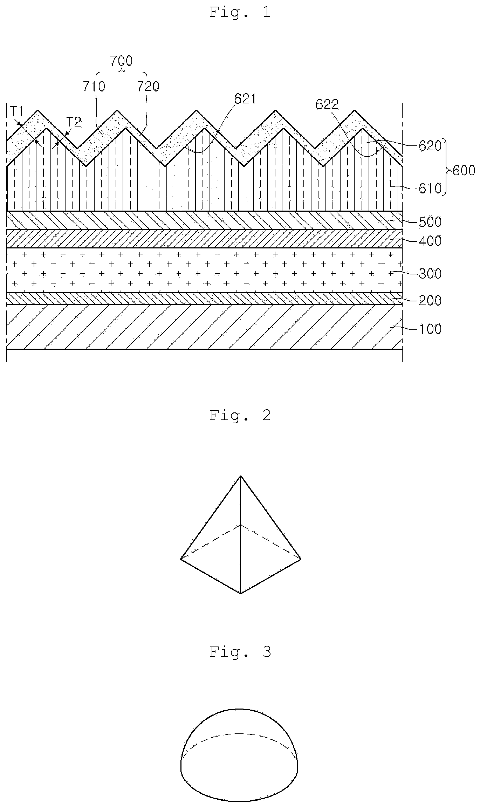

FIG. 1 is a sectional view showing a solar cell according to the embodiment, and FIGS. 2 to 4 are perspective views showing various examples of an anti-reflective pattern.

Referring to FIG. 1, the solar cell includes a support substrate 100, a back electrode layer 200, a light absorbing layer 300, a buffer layer 400, a high resistance buffer layer 500, a window layer 600, and an anti-reflective layer 700.

The support substrate 100 has a plate shape and supports the back electrode layer 200, the light absorbing layer 300, the buffer layer 400, the high resistance buffer layer 500, and the window layer 600.

The support substrate 100 may include an insulator. The support substrate 100 may include a glass substrate, a plastic substrate, or a metallic substrate. In more detail, the support substrate 100 may include a soda lime glass substrate. The support substrate 100 may be transparent or may be rigid or flexible.

The back electrode layer 200 is provided on the substrate 100. The back electrode layer 200 may be a conductive layer. The back electrode layer 200 may include a metal, such as molybdenum (Mo).

In addition, the back electrode layer 200 may include at least two layers. In this case, the layers may be formed by using the homogeneous metal or heterogeneous metals.

The light absorbing layer 300 is provided on the back electrode layer 200. The light absorbing layer 300 includes a group I-III-VI compound. For example, the light absorbing layer 300 may have a Cu(In,Ga)Se₂ (CIGS) crystal structure, a Cu(In)Se₂ crystal structure, or a Cu(Ga)Se₂ crystal structure.

The light absorbing layer 300 may have an energy bandgap in the range of about 1eV to about 1.8eV.

The buffer layer 400 is provided on the light absorbing layer 300. The buffer layer 400 directly makes contact with the light absorbing layer 300.

The buffer layer 400 may include CdS. The buffer layer 400 may have the energy bandgap in the range of about 1.9eV to about 2.3eV.

The high resistance buffer layer 500 is provided on the buffer layer 400. The high-resistance buffer layer 500 may include iZnO, which is zinc oxide not doped with impurities. The high resistance buffer layer 500 has an energy bandgap in the range of about 3.1eV to about 3.3eV.

The window layer 600 is provided on the high resistance buffer layer 500. The window layer 600 is transparent, and includes a conductive layer. In addition, the window layer 600 may include Al doped ZnO (AZO).

The window layer 600 includes a base layer 610 and an anti-reflective pattern 620.

The base layer 610 is provided on the high resistance buffer layer 500. The anti-reflective pattern 620 protrudes from the base layer 610. In other words, the anti-reflective pattern 620 is a protrusion pattern. The base layer 610 may be integrally formed with the anti-reflective pattern 620.

As shown in FIGS. 2 to 4, the anti-reflective pattern 620 may have various shapes. For example, the anti-reflective pattern 620 may have a pyramid shape, a hemispheric shape, or a triangular prim shape.

The anti-reflective pattern 620 may have a height in the range of about 100nm to about 500nm. The height of the anti-reflective pattern 620 may correspond to about 10% to about 50% of the thickness of the window layer 600.

The anti-reflective pattern 620 includes first inclined surfaces 621 and second inclined surfaces 622.

The first inclined surfaces 621 are directed to a first direction. The first inclined surfaces 621 may extend in the same direction. The first inclined surfaces 621 are inclined with respect to a top surface of the support substrate 100. In other words, the first inclined surfaces 621 are inclined with respect to a top surface of the back electrode layer 200 and a top surface of the light absorbing layer 300.

An angle between the first inclined surfaces 621 and to top surface of the light absorbing layer 300 may be in the range of about 20° to about 60°. Similarly, an angle between the first inclined surfaces 621 and the top surface of the back electrode layer 200 may be in the range of about 20° to about 60°.

The second inclined surfaces 622 are directed to a second direction different from the first direction. The second inclined surfaces 622 may extend in the same direction. The second inclined surfaces 622 may face the first inclined surfaces 621. For example, the second inclined surfaces 622 are symmetrical to the first inclined surfaces 621.

The second inclined surfaces 622 are inclined with respect to the top surface of the support substrate 100. In other words, the second inclined surfaces 622 are inclined with respect to the top surface of the back electrode layer 200 and the top surface of the light absorbing layer 300.

An angle between the second inclined surfaces 622 and the top surface of the light absorbing layer 300 may be in the range of about 20° to about 60°. Similarly, an angle between the second inclined surfaces 622 and the top surface of the back electrode layer 200 may be in the range of about 20° to about 60°.

The anti-reflective layer 700 is provided on the window layer 600. The anti-reflective layer 700 is coated on the top surface of the window layer 600. In more detail, the anti-reflective layer 700 covers the anti-reflective pattern 620. The anti-reflective layer 700 is coated on the surface of the anti-reflective pattern 620.

The anti-reflective layer 700 is transparent. The anti-reflective layer 700 may include anti-reflective coating material such as MgF₂ or LiF.

The anti-reflective layer 700 includes a fist anti-reflective layer 710 and a second anti-reflective layer 720.

The first anti-reflective layer 710 is provided on the first inclined surfaces 621. The first anti-reflective layer 710 is coated on the first inclined surfaces 621.

The first anti-reflective layer 710 has a first thickness T1 having a greater size. The first thickness T1 of the first anti-reflective layer 710 may be in the range of about 100nm to about 500nm.

The second anti-reflective layer 720 is provided on the second inclined surfaces 621. The second anti-reflective layer 720 is coated on the second inclined surfaces 622.

The second anti-reflective layer 720 has a second thickness T1 having a smaller size. The second thickness T2 of the second anti-reflective layer 720 may be in the range of about 50nm to about 450nm. The second thickness T2 is smaller than the first thickness T1. In this case, the difference between the first thickness T1 and the second thickness T2 may be in the range of about 10nm to about 100nm.

The first anti-reflective layer 710 is integrally formed with the second anti-reflective layer 720. In other words, the first anti-reflective layer 710 and the second anti-reflective layer 720 constitute one layer.

Since the first anti-reflective layer 710 and the second anti-reflective layer 720 have thicknesses T1 and T2 different from each other, the first anti-reflective layer 710 and the second anti-reflective layer 720 make constructive interference at wavelength bands different from each other.

In other words, an optical path difference between a first light reflected from the first anti-reflective layer 710 and a second light reflected from the first inclined surfaces 621 is twice greater than the first thickness T1. The first and second lights make constructive interference at a specific wavelength band due to the optical path difference.

Similarly, an optical path difference between a third light reflected from the second anti-reflective layer 720 and a fourth light reflected from the second inclined surfaces 622 is twice greater than the second thickness T2. The third and fourth lights make constructive interference at a specific wavelength band due to the optical path difference.

In this case, since the first thickness T1 is different from the second thickness T2, wavelength bands making constructive interference are different from each other. Accordingly, observed colors are different from each other.

Therefore, different colors may be observed according to viewing angles for the anti-reflective layer 700.

Therefore, the solar cell according to the embodiment can have an improved external appearance.

In addition, the light incident efficiency of the window layer 600 is improved due to the anti-reflective layer 700 and the anti-reflective pattern 620.

Therefore, the solar cell according to the embodiment can represent improved efficiency.

Although the present embodiment has been described in that the anti-reflective pattern 620 formed in the window layer 600 is coated with the anti-reflective layers 700 having thicknesses different from each other, the embodiment is not limited thereto. Accordingly, the embodiment may have a structure in which anti-reflective layers having different thicknesses are coated on the anti-reflective pattern 620 formed in a protective glass provided on the window layer 600.

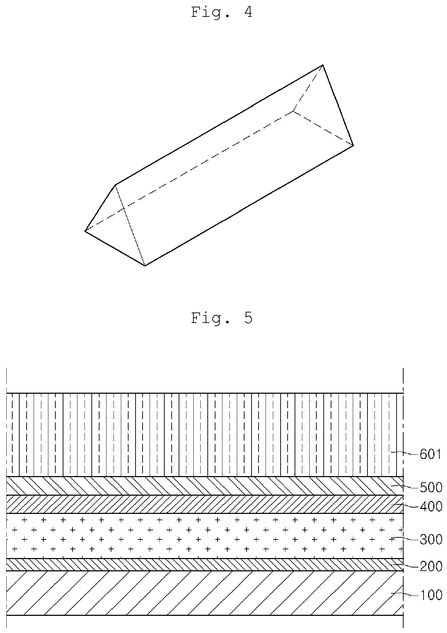

FIGS. 5 to 8 are sectional views showing the fabricating process of the solar cell according to the embodiment. Hereinafter, the present fabrication method will be described by making reference to the above description of the solar cell. The description of the present fabrication method will be incorporated in the above description of the solar cell.

Referring to FIG. 5, the back electrode layer 200 is formed by depositing a metal such as molybdenum (Mo) on the support substrate 100 through a sputtering process. The back electrode layer 200 may be formed through two processes having process conditions different from each other.

An additional layer such as an anti-diffusion layer may be interposed between the support substrate 100 and the back electrode layer 200.

The light absorbing layer 300 is formed on the back electrode layer 200.

The light absorbing layer 300 may be formed through a sputtering process or an evaporation scheme.

For example, the light absorbing layer 300 may be formed through various schemes such as a scheme of forming a Cu(In,Ga)Se2 (CIGS) based light absorbing layer 300 by simultaneously or separately evaporating Cu, In, Ga, and Se and a scheme of performing a selenization process after a metallic precursor layer has been formed.

Regarding the details of the selenization process after the formation of the metallic precursor layer, the metallic precursor layer is formed on the back electrode layer 200 through a sputtering process employing a Cu target, an In target, a Ga target or an alloy target.

Thereafter, the metallic precursor layer is subject to the selenization process so that the Cu (In, Ga) Se2 (CIGS) based light absorbing layer 300 is formed.

In addition, the sputtering process employing the Cu target, the In target, and the Ga target and the selenization process may be simultaneously performed.

Further, a CIS or a CIG based light absorbing layer 300 may be formed through the sputtering process employing only Cu and In targets or only Cu and Ga targets and the selenization process.

Thereafter, the buffer layer 400 is formed on the light absorbing layer 300. The buffer layer 400 may be formed by depositing CdS on the light absorbing layer 300 through a chemical bath deposition (CBD) process.

The high-resistance buffer layer 500 is formed by depositing zinc oxide on the buffer layer 400 through a sputtering process.

A preliminary window layer 601 is formed on the high resistance buffer layer 500. In order to form the preliminary window layer 601, a transparent conductive material is laminated on the high resistance buffer layer 500. The transparent conductive material may include AZO.

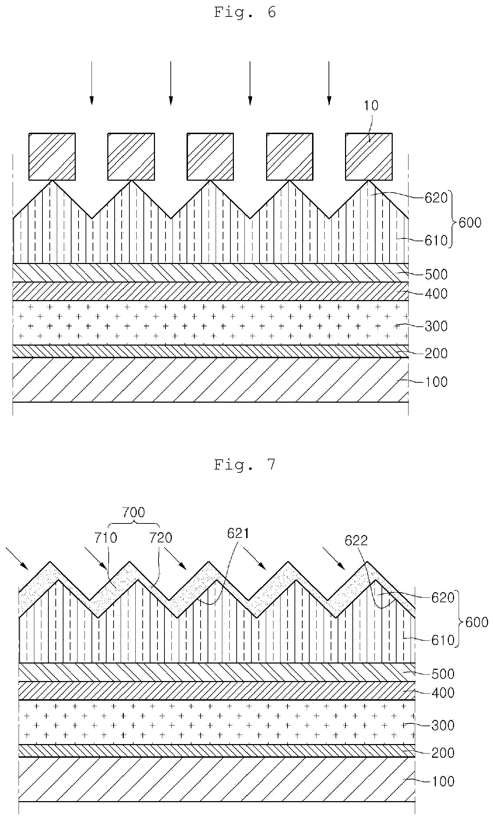

Referring to FIG. 6, a mask pattern 10 is formed on the preliminary window layer 601. The mask pattern 10 may be formed through a photolithography process.

Thereafter, the preliminary window layer 601 is etched by using an etching solution, thereby forming the window layer 600 including the base layer 610 and the anti-reflective pattern 620. The etching solution may include a hydrochloric acid solution.

In addition, the top surface of the preliminary window layer 601 may be subject to surface-treatment by using etching particles such as micro sands without employing the mask pattern.

Referring to FIG. 7, the anti-reflective layer 700 is formed on the window layer 600. In order to form the anti-reflective layer 700, a material used to form the anti-reflective layer 700 is deposited on the support substrate 100 while inclining a deposition direction of the material.

For example, MgF₂ or LiF particles are spread on the window layer 600 from an MgF₂ sputtering target or an LiF sputtering target while inclining a deposition direction of the MgF₂ or LiF particles. The spread direction of the above particles may be inclined at an angle of about 20° to about 60° with respect to the top surface of the support substrate 100.

The materials used to form the anti-reflective layer 700 are spread toward the first inclined surfaces 621.

Therefore, the first anti-reflective layer 710 having the first thickness T1 in a greater size is formed on the first inclined surfaces 621, and the second anti-reflective layer 720 having the second thickness T2 in a smaller size is formed on the second inclined surfaces 622.

As described above, according to the method of fabricating the solar cell of the embodiment, a solar cell having an improved external appearance and improved efficiency can be fabricated.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar cell apparatus comprising:
a substrate (100),
a back electrode layer (200) on the substrate (100);
a light absorbing layer (300) on the back electrode layer (200);
a window layer (600), on the light absorbing layer (300), including a base layer (610) and an anti-reflective pattern (620) protruding from said base layer (610), the anti-reflective pattern (620) including a first inclined surface (621), directed to a first direction, and a second inclined surface (622), directed to a second direction, the first inclined surface (621) and the second inclined surface (622) being inclined with respect to a top surface of the back electrode layer (200) in mutually different directions;
an anti-reflective layer (700) provided on the window layer (600);
wherein the anti-reflective layer (700) has a first anti-reflective layer (710) and a second anti-reflective layer (720), the first anti-reflective layer (710) and the second anti-reflective layer (720) being integrally formed with each other;
wherein ends of the first inclined surface (621) are connected with the second inclined surface (622) and ends of the second inclined surface (622) are connected with the first inclined surface (621);
wherein the first anti-reflective layer (710) is coated on the first inclined surface (621) and having a first uniform thickness T1;
wherein the second anti-reflective layer (720) is coated on the second inclined surface (622) and having a second uniform thickness T2 thinner than the first thickness T1;
wherein the first thickness T1 is in a range of 100 nm to 500 nm;
wherein the second thickness T2 is in a range of 50 nm to 450 nm; and
wherein a difference between the first and second thicknesses T1 and T2 is in a range of 10 nm to 100 nm.

2. The solar cell apparatus of claim 1, wherein an angle between the first inclined surface (621) and the top surface of the back electrode layer (200) and an angle between the second inclined surface (622) and the top surface of the back electrode layer (200) are in a range of 20° to 60°.

3. The solar cell apparatus of claim 1, wherein the first and second anti-reflective layers (710, 720) include MgF₂ or LiF.

4. The solar cell apparatus of claim 1, wherein the anti-reflective pattern (620) has a pyramidal shape.

5. The solar cell apparatus of claim 1, further comprising:
a third anti-reflective layer on the first anti-reflective layer (710); and
a fourth anti-reflective layer on the second anti-reflective layer (720),
wherein the third anti-reflective layer has a thickness thicker than a thickness of the fourth anti-reflective layer.

6. A method of manufacturing a solar cell apparatus, the method comprising:
forming a back electrode layer (200) on a substrate (100);
forming a light absorbing layer (300) on the back electrode layer (200);
forming a window layer (600), on the light absorbing layer (300), including a base layer (610) and an anti-reflective pattern (620) protruding from said base layer (610), the anti-reflective pattern (620) including a first inclined surface (621), directed to a first direction, and a second inclined surface (622), directed to a second direction, the first inclined surface (621) and the second inclined surface (622) being inclined with respect to a top surface of the back electrode layer (200) in mutually different directions;
forming an anti-reflective layer (700) on the window layer (600);
wherein the anti-reflective layer (700) has a first anti-reflective layer (710) and a second anti-reflective layer (720), the first anti-reflective layer (710) and the second anti-reflective layer (720) being integrally formed with each other;
wherein ends of the first inclined surface (621) are connected with the second inclined surface (622) and ends of the second inclined surface (622) are connected with the first inclined surface (621);
wherein the first anti-reflective layer (710) is coated on the first inclined surface (621) and having a first uniform thickness T1; and
wherein the second anti-reflective layer (720) is coated on the second inclined surface (622) and having a second uniform thickness T2 thinner than the first thickness;
wherein the first thickness T1 is in a range of 100 nm to 500 nm;
wherein the second thickness T1 is in a range of 50 nm to 450 nm; and
wherein a difference between the first and second thicknesses T1 and T2 is in a range of 10 nm to 100 nm.

7. The method of claim 6, wherein, in the forming of the first and second anti-reflective layers (710, 720), the source materials are deposited in the direction inclined with respect to the top surface of the back electrode layer (200) at an angle of 20° to 60°.

8. The method of claim 7, wherein the anti-reflective pattern (620) has a height in a range of 100 nm to 500 nm.

9. The method of claim 6, wherein the forming of the anti-reflective pattern (620) comprises:
forming a transparent conductive layer on the light absorbing layer (300); and
etching a part of the transparent conductive layer.

10. The method of claim 6, further comprising:
forming a third anti-reflective layer on the first anti-reflective layer (710); and
forming a fourth anti-reflective layer on the second anti-reflective layer (720),
wherein the third anti-reflective layer has a thickness thicker than a thickness of the fourth anti-reflective layer.

## Patentansprüche

1. Solarzellenvorrichtung, umfassend:
ein Substrat (100),
eine Rückelektrodenschicht (200) auf dem Substrat (100) ;
eine lichtabsorbierende Schicht (300) auf der Rückelektrodenschicht (200);
eine Fensterschicht (600) auf der lichtabsorbierenden Schicht (300), die eine Grundschicht (610) und ein Antireflexionsmuster (620) einschließt, welches von der Grundschicht (610) vorspringt, wobei das Antireflexionsmuster (620) eine erste geneigte Fläche (621), die in eine erste Richtung gerichtet ist, und eine zweite geneigte Fläche (622) einschließt, die in eine zweite Richtung gerichtet ist, wobei die erste geneigte Fläche (621) und die zweite geneigte Fläche (622) in Bezug auf eine obere Fläche der Rückelektrodenschicht (200) in voneinander verschiedene Richtungen geneigt sind;
eine Antireflexionsschicht (700), die auf der Fensterschicht (600) bereitgestellt ist;
wobei die Antireflexionsschicht (700) eine erste Antireflexionsschicht (710) und eine zweite Antireflexionsschicht (720) aufweist, wobei die erste Antireflexionsschicht (710) und die zweite Antireflexionsschicht (720) einstückig miteinander gebildet sind;
wobei Enden der ersten geneigten Fläche (621) mit der zweiten geneigten Fläche (622) verbunden sind, und Enden der zweiten geneigten Fläche (622) mit der ersten geneigten Fläche (621) verbunden sind;
wobei die erste Antireflexionsschicht (710) auf die erste geneigte Fläche (621) gezogen ist und eine erste gleichmäßige Dicke T1 aufweist;
wobei die zweite Antireflexionsschicht (720) auf die zweite geneigte Fläche (622) gezogen ist und eine zweite gleichmäßige Dicke T2 aufweist, die dünner ist als die erste Dicke T1;
wobei die erste Ticke T1 in einem Bereich von 100 nm bis 500 nm liegt;
wobei die zweite Dicke T2 in einem Bereich von 50 nm bis 450 nm liegt; und
wobei eine Differenz zwischen der ersten und zweiten Dicke T1 und T2 in einem Bereich von 10 nm bis 100 nm liegt.

2. Solarzellenvorrichtung nach Anspruch 1, wobei ein Winkel zwischen der ersten geneigten Fläche (621) und der oberen Fläche der Rückelektrodenschicht (200), und ein Winkel zwischen der zweiten geneigten Fläche (622) und der oberen Fläche der Rückelektrodenschicht (200) in einem Bereich von 20° bis 60° liegen.

3. Solarzellenvorrichtung nach Anspruch 1, wobei die erste und zweite Antireflexionsschicht (710, 720) MgF₂ oder LiF einschließen.

4. Solarzellenvorrichtung nach Anspruch 1, wobei das Antireflexionsmuster (620) eine Pyramidenform aufweist.

5. Solarzellenvorrichtung nach Anspruch 1, weiter umfassend:
eine dritte Antireflexionsschicht auf der ersten Antireflexionsschicht (710); und
eine vierte Antireflexionsschicht auf der zweiten Antireflexionsschicht (720),
wobei die dritte Antireflexionsschicht eine Dicke aufweist, die dicker ist als eine Dicke der vierten Antireflexionsschicht.

6. Verfahren zur Herstellung einer Solarzellenvorrichtung, wobei das Verfahren umfasst:
Bilden einer Rückelektrodenschicht (200) auf einem Substrat (100);
Bilden einer lichtabsorbierenden Schicht (300) auf der Rückelektrodenschicht (200);
Bilden einer Fensterschicht (600) auf der lichtabsorbierenden Schicht (300), die eine Grundschicht (610) und ein Antireflexionsmuster (620) einschließt, welches von der Grundschicht (610) vorspringt, wobei das Antireflexionsmuster (620) eine erste geneigte Fläche (621), die in eine erste Richtung gerichtet ist, und eine zweite geneigte Fläche (622) einschließt, die in eine zweite Richtung gerichtet ist, wobei die erste geneigte Fläche (621) und die zweite geneigte Fläche (622) in Bezug auf eine obere Fläche der Rückelektrodenschicht (200) in voneinander verschiedene Richtungen geneigt sind;
Bilden einer Antireflexionsschicht (700) auf der Fensterschicht (600);
wobei die Antireflexionsschicht (700) eine erste Antireflexionsschicht (710) und eine zweite Antireflexionsschicht (720) aufweist, wobei die erste Antireflexionsschicht (710) und die zweite Antireflexionsschicht (720) einstückig miteinander gebildet sind;
wobei Enden der ersten geneigten Fläche (621) mit der zweiten geneigten Fläche (622) verbunden sind, und Enden der zweiten geneigten Fläche (622) mit der ersten geneigten Fläche (621) verbunden sind;
wobei die erste Antireflexionsschicht (710) auf die erste geneigte Fläche (621) gezogen ist und eine erste gleichmäßige Dicke T1 aufweist; und
wobei die zweite Antireflexionsschicht (720) auf die zweite geneigte Fläche (622) gezogen ist und eine zweite gleichmäßige Dicke T2 aufweist, die dünner ist als die erste Dicke;
wobei die erste Ticke T1 in einem Bereich von 100 nm bis 500 nm liegt;
wobei die zweite Dicke T1 in einem Bereich von 50 nm bis 450 nm liegt; und
wobei eine Differenz zwischen der ersten und zweiten Dicke T1 und T2 in einem Bereich von 10 nm bis 100 nm liegt.

7. Verfahren nach Anspruch 6, wobei die Ausgangsmaterialien beim Bilden der ersten und zweiten Antireflexionsschicht (710, 720) in der Richtung abgeschieden werden, die in Bezug auf die obere Fläche der Rückelektrodenschicht (200) in einem Winkel von 20° bis 60° geneigt ist.

8. Verfahren nach Anspruch 7, wobei das Antireflexionsmuster (620) eine Höhe in einem Bereich von 100 nm bis 500 nm aufweist.

9. Verfahren nach Anspruch 6, wobei das Bilden des Antireflexionsmusters (620) umfasst:
Bilden einer transparenten leitfähigen Schicht auf der lichtabsorbierenden Schicht (300); und
Ätzen eines Teils der transparenten leitfähigen Schicht.

10. Verfahren nach Anspruch 6, weiter umfassend:
Bilden einer dritten Antireflexionsschicht auf der ersten Antireflexionsschicht (710); und
Bilden einer vierten Antireflexionsschicht auf der zweiten Antireflexionsschicht (720),
wobei die dritte Antireflexionsschicht eine Dicke aufweist, die dicker ist als eine Dicke der vierten Antireflexionsschicht.

## Revendications

1. Appareil à cellule solaire comprenant :
un substrat (100),
une couche d'électrode arrière (200) sur le substrat (100) ;
une couche d'absorption de lumière (300) sur la couche d'électrode arrière (200) ;
une couche fenêtre (600), sur la couche d'absorption de lumière (300), comportant une couche de base (610) et un motif antireflet (620) faisant saillie de ladite couche de base (610), le motif antireflet (620) comportant une première surface inclinée (621), dirigée vers une première direction, et une seconde surface inclinée (622), dirigée vers une seconde direction, la première surface inclinée (621) et la seconde surface inclinée (622) étant inclinées par rapport à une surface supérieure de la couche d'électrode arrière (200) dans des directions mutuellement différentes ;
une couche antireflet (700) fournie sur la couche fenêtre (600) ;
dans lequel la couche antireflet (700) a une première couche antireflet (710) et une deuxième couche antireflet (720), la première couche antireflet (710) et la deuxième couche antireflet (720) étant formées d'un seul tenant l'une avec l'autre ;
dans lequel des extrémités de la première surface inclinée (621) sont reliées à la seconde surface inclinée (622) et des extrémités de la seconde surface inclinée (622) sont reliées à la première surface inclinée (621) ;
dans lequel la première couche antireflet (710) est revêtue sur la première surface inclinée (621) et ayant une première épaisseur uniforme T1 ;
dans lequel la deuxième couche antireflet (720) est revêtue sur la seconde surface inclinée (622) et ayant une seconde épaisseur uniforme T2 inférieure à la première épaisseur T1 ;
dans lequel la première épaisseur T1 est dans une plage de 100 nm à 500 nm ;
dans lequel la seconde épaisseur T2 est dans une plage de 50 nm à 450 nm ; et
dans lequel une différence entre les première et seconde épaisseurs T1 et T2 est dans une plage de 10 nm à 100 nm.

2. Appareil à cellule solaire selon la revendication 1, dans lequel un angle entre la première surface inclinée (621) et la surface supérieure de la couche d'électrode arrière (200) et un angle entre la seconde surface inclinée (622) et la surface supérieure de la couche d'électrode arrière (200) sont dans une plage de 20° à 60°.

3. Appareil à cellule solaire selon la revendication 1, dans lequel les première et deuxième couches antireflets (710, 720) comportent MgF₂ ou LiF.

4. Appareil à cellule solaire selon la revendication 1, dans lequel le motif antireflet (620) a une forme pyramidale.

5. Appareil à cellule solaire selon la revendication 1, comprenant en outre :
une troisième couche antireflet sur la première couche antireflet (710) ; et
une quatrième couche antireflet sur la deuxième couche antireflet (720),
dans lequel la troisième couche antireflet a une épaisseur supérieure à une épaisseur de la quatrième couche antireflet.

6. Procédé de fabrication d'un appareil à cellule solaire, le procédé comprenant :
la formation d'une couche d'électrode arrière (200) sur un substrat (100) ;
la formation d'une couche d'absorption de lumière (300) sur la couche d'électrode arrière (200) ;
la formation d'une couche fenêtre (600), sur la couche d'absorption de lumière (300), comportant une couche de base (610) et un motif antireflet (620) faisant saillie de ladite couche de base (610), le motif antireflet (620) comportant une première surface inclinée (621), dirigée vers une première direction, et une seconde surface inclinée (622), dirigée vers une seconde direction, la première surface inclinée (621) et la seconde surface inclinée (622) étant inclinées par rapport à une surface supérieure de la couche d'électrode arrière (200) dans des directions mutuellement différentes ;
la formation d'une couche antireflet (700) sur la couche fenêtre (600) ;
dans lequel la couche antireflet (700) a une première couche antireflet (710) et une deuxième couche antireflet (720), la première couche antireflet (710) et la deuxième couche antireflet (720) étant formées d'un seul tenant l'une avec l'autre ;
dans lequel des extrémités de la première surface inclinée (621) sont reliées à la seconde surface inclinée (622) et des extrémités de la seconde surface inclinée (622) sont reliées à la première surface inclinée (621) ;
dans lequel la première couche antireflet (710) est revêtue sur la première surface inclinée (621) et ayant une première épaisseur uniforme T1 ; et
dans lequel la deuxième couche antireflet (720) est revêtue sur la seconde surface inclinée (622) et ayant une seconde épaisseur uniforme T2 inférieure à la première épaisseur ;
dans lequel la première épaisseur T1 est dans une plage de 100 nm à 500 nm ;
dans lequel la seconde épaisseur T1 est dans une plage de 50 nm à 450 nm ; et
dans lequel une différence entre les première et seconde épaisseurs T1 et T2 est dans une plage de 10 nm à 100 nm.

7. Procédé selon la revendication 6, dans lequel, lors de la formation des première et deuxième couches antireflets (710, 720), les matériaux sources sont déposés dans la direction inclinée par rapport à la surface supérieure de la couche d'électrode arrière (200) selon un angle de 20° à 60°.

8. Procédé selon la revendication 7, dans lequel le motif antireflet (620) a une hauteur dans une plage de 100 nm à 500 nm.

9. Procédé selon la revendication 6, dans lequel la formation du motif antireflet (620) comprend :
la formation d'une couche conductrice transparente sur la couche d'absorption de lumière (300) ; et
la gravure d'une partie de la couche conductrice transparente.

10. Procédé selon la revendication 6, comprenant en outre :
la formation d'une troisième couche antireflet sur la première couche antireflet (710) ; et
la formation d'une quatrième couche antireflet sur la deuxième couche antireflet (720),
dans lequel la troisième couche antireflet a une épaisseur supérieure à une épaisseur de la quatrième couche antireflet.
